# EUROPEAN PATENT SPECIFICATION

(11) **EP 1 335 806 B1**
(45) Date of publication and mention of the grant of the patent: **21.06.2006**
(21) Application number: 01927316.8
(22) Date of filing: 24.04.2001
(51) Int. Cl.: B22F 1/00, C23G 5/024, C23C 22/02

(54) **IMPROVED PASSIVATING ETCHANTS FOR METALLIC PARTICLES**
PASSIVIERUNGSÄTZMITTEL FÜR METALLPULVER
REACTIFS D'ATTAQUE PASSIVANTS AMELIORES POUR PARTICULES METALLIQUES

(30) Priority: 25.10.2000 US 674061
(43) Date of publication of application: 20.08.2003
(73) Proprietor: Midwest Research Institute, Kansas City Missouri 64110 (US)
(72) Inventor: SCHULZ, Douglas, L., Billerica, MA 01821 (US); GINLEY, David, S., Evergreen, CO 80439 (US); CURTIS, Calvin, J., Lakewood, CO 80232 (US)
(74) Representative: Steinecke, Peter
(86) International application number: PCT/US2001/013132
(87) International publication number: WO 2002/034435

(56) References cited:
- WO-A-00/43573
- WO-A-92/08561
- CURTIS C J ET AL: "Direct write metallizations for Ag and Al" MATERIALS DEVELOPMENT FOR DIRECT WRITE TECHNOLOGIES;SAN FRANCISCO, CA, UNITED STATES APR 24-26 2000, vol. 624, 2000, pages 59-64, XP001041321 Mater Res Soc Symp Proc;Materials Research Society Symposium - Proceedings 2000
- GEORGE M A ET AL: "REACTION OF 1,1,1,5,5,5-HEXAFLUORO-2,4-PENTANEDIONE (H+HFAC) WITH CUO, CU2O, AND CU FILMS" JOURNAL OF THE ELECTROCHEMICAL SOCIETY, ELECTROCHEMICAL SOCIETY. MANCHESTER, NEW HAMPSHIRE, US, vol. 142, no. 3, 1 March 1995 (1995-03-01), pages 961-965, XP000504904 ISSN: 0013-4651
- DATABASE CA [Online] CHEMICAL ABSTRACTS SERVICE, COLUMBUS, OHIO, US; LEDBETTER, JAMES WILLIE, JR.: "The effects of temperature and reactive environments on metal particle sintering and redispersion" retrieved from STN Database accession no. 131:7039 XP002183190 & (1998) 350 PP. AVAIL.: UMI, ORDER NO. DA9904519 FROM: DISS. ABSTR. INT., B 1999, 59(9), 4962,

## Description

### Contractual Origin of the Invention:

The United States Government has rights to this invention pursuant to Contract No. DE-AC36-99GO-10337 between the United States Department of Energy and the Midwest Research Institute.

Pursuant to 35 U.S.C 120, 365(c) and 119(e) this application is a continuation-in-part of PCT/US00/01742, an international application designating the United States, filed 21 January 2000 claiming the benefit of U.S. Ser. No. 60/116,561, a 35 USC 111(b) application, filed 21 January 1999.

### Tchnical Field:

This invention relates to etchants for Cu metallic particles, and in particular a method for etching oxide and hydroxide corrosion layers, or both, from the surface of Cu metallic particles and passivating the surfaces for use in the formation of thin film conductors, and the like.

### Background Art:

There is a push in the microelectronics and photovoltaics industries to replace traditional metallization processes, such as high vacuum sputtering or evaporation, and screen printing, with simple and less costly processes. For example, as applied in the field of photovoltaics, traditional metallization processes require a mask-based step prior to the deposition of metal films or lines, to extract current, on the junction part of the device. Improved direct write processes for printing conducting metal layers and grids using a non-vacuum spray or ink-jet deposition apparatus is one viable alternative to the traditional methods. Ink-jet printing has the further advantage of depositing very narrow grid lines resulting in a decrease in shading losses and an increase in efficiency. However, in order to realize a commercially viable direct write metallization process, new metal-particle based inks must be developed, because current methods for application of these particles have been hampered by a lack of good interparticle connectivity when the particles are directly deposited as films to substrates. This connectivity, both structural and electrical, is in many cases limited by the formation of a corrosion layer (i.e., oxide or hydroxide) contaminating the surface of the particles. These passivated surfaces generally give rise to an insulating effect electrically and an impedance in particle sintering structurally.

In order to form a thin-film, for use in photoconversion and microelectronic device applications, the regions coated with particles have traditionally been sintered to ensure electrical continuity across the feature. High temperature sintering often eliminates some of the problems associated with surface contamination. However, when used in the formation of nanoparticle contacts to photovoltaic semiconductors, standard high-temperature sintering often cannot be performed due to the thermal limitations associated with the underlying layers of the device.

Chemical etches have also been used to remove the oxide coating on nano-phase metals, such as aluminum, Petzow, G., *Metallographic Etching,* American Society of Metals, 39-42 (1978), but these etches have been found to completely dissolve the nanoparticles. Treatment with a variety of organic chelating agents is known from WO 00 43573. What is needed is a method for etching Cu particles, to be used as inks in the metallization of microelectronics.

### Disclosure of Invention:

Accordingly, it is a primary object of the present invention to provide a method for etching the oxide and hydroxide corrosion layers, or both, from the surface of Cu metallic particles and passivating the surfaces for use in the formation of thin film conductors, and the like.

It is another object of the invention to improve the electrical conductivity for particle derived metal contacts.

Another object of the present invention is to provide an improved method for forming ohmic contacts from copper metallic particles with a *p*-type silicon layer in a silicon solar cell.

These and other objects of the present invention will become apparent throughout the description of the invention which now follows.

In order to overcome the problems associated with the background art, the invention provides a process for etching the corrosion layer from and passivating the surface of Cu metallic particles, comprising forming a reaction mixture by dispersing particles, having a passivating surface layer, in a solution comprising a hexafluoroacetylacetonate metal chelate, and reacting the mixture for a time sufficient to etch and passivate the surface.

### Brief Description of Drawings:

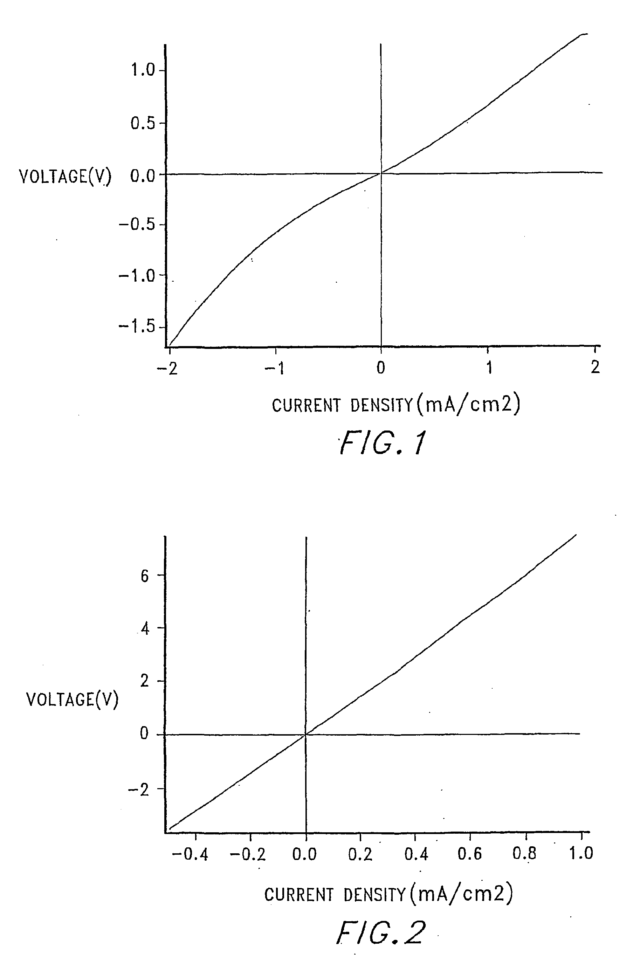

Figure 1 shows the current-voltage characteristics of a solar cell where particulate aluminum is slurried ontop-type silicon and annealed at 645°C in argon for one hour. This is a control sample.
Figure 2 shows the current-voltage characteristics of a solar cell where particulate aluminum is etched/passivated with Na(hfa), slurried onto *p*-type Si, and annealed at 649°C in argon for one hour.

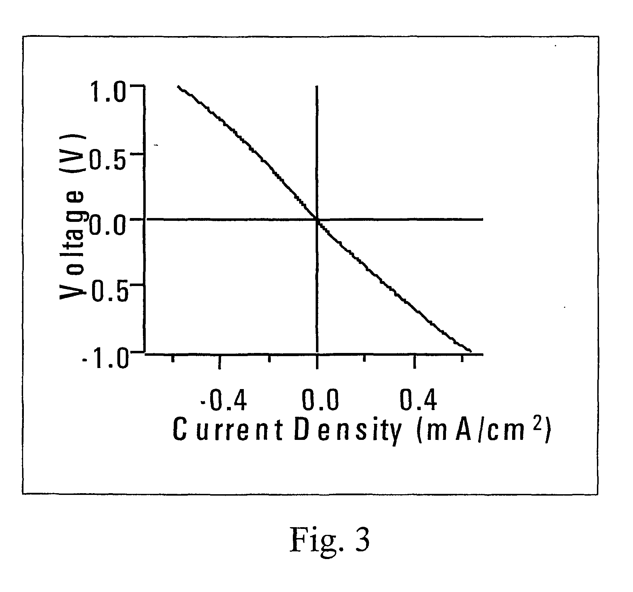

Figure 3 shows the I-V curve for contact to *p*-type silicon derived from oxide-coated nano-aluminum.

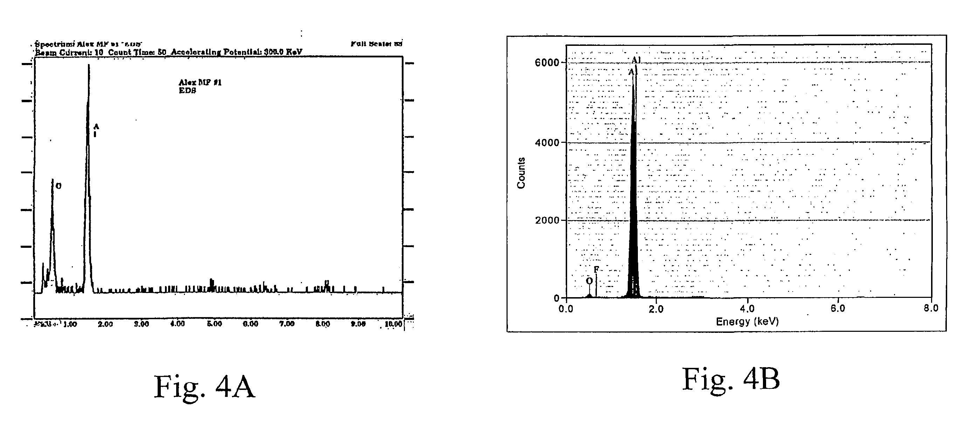

Figure 4(A) shows the TEM-EDS characterization of nano-aluminum before and 4(B) after treatment with Hhfa.

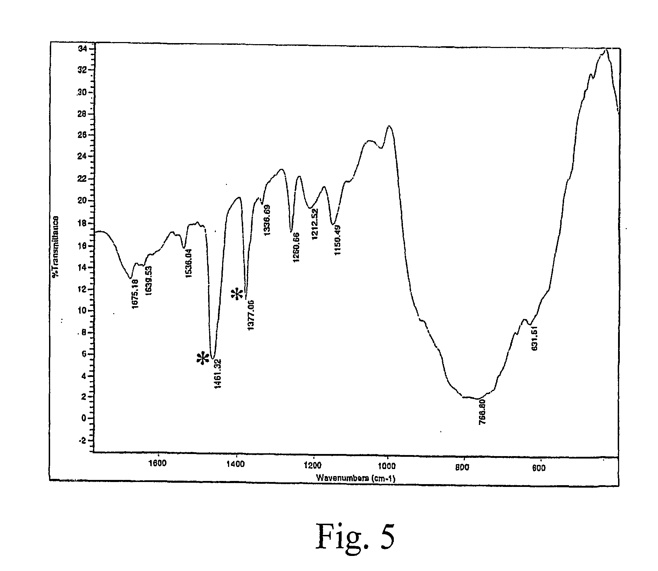

Figure 5 shows the FT-IR spectrum obtained from a Nujol mull of treated nano-aluminum powder. The Nujol peaks are marked with an "*".

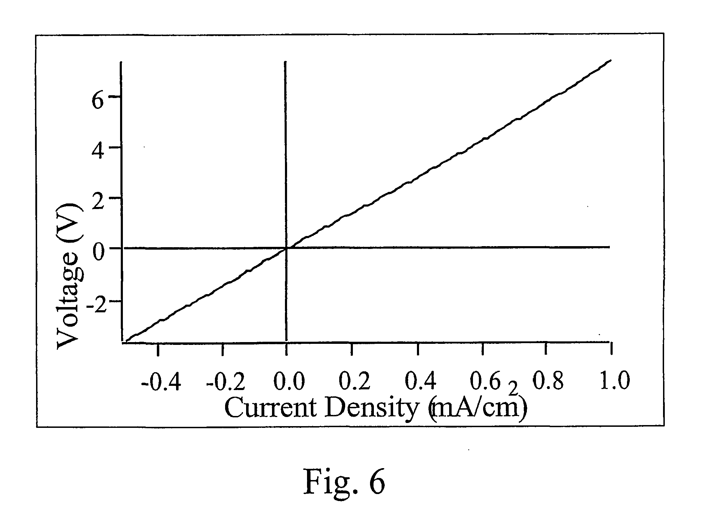

Figure 6 is the linear I-V curve for contact to *p*-type silicon derived from Hhfa-treated nano-aluminum.
Figure 7(A) shows the XRD characterization of the oxide coated copper nanoparticles, as received. Figure 7(B) shows that, pursuant to XRD characterization, after etching the particles in Hhfa, the oxide coating was removed.

### Best Mode for Carrying Out the Invention:

Unless specifically defined otherwise, all technical or scientific terms used herein have the same meaning as commonly understood by one of ordinary skill in the art to which this invention belongs. Although any methods and materials similar or equivalent to those described herein can be used in the practice or testing of the present invention, the presently preferred methods and materials are now described.

The etchant, in accordance with the present invention, is a metal chelate organometallic complex which removes the oxide and hydroxide corrosion layers, or both, from the surface of Cu metallic particles and passivate the surfaces for use in the formation of thin film conductors, and the like. The metal chelate is a purely synthetic compound which etches cleanly at low temperature. The metal-chelates comprise hexafluoroacetylacetone and include the organometallic complex Cu(hfa)•VTMS, and neat hexafluoroacetylacetone (Hhfa), where hfac = 1,1,1,5,5,5-hexafluoroacetylacetonate, and VTMS is vinyltrimethylsilane. VTMS has the additional advantage of acting as a stabilizer.

The metal Cu nanoparticles, to be etched, preferably have a mean particle diameter in the range of 1 to 500 nanometers, and more particularly in the range of 1 and 100 nanometers. The nanoparticles may be produced according to any method well known in the art, such as the Argonide Corporation's, Sanford, FL, nano copper particles, which are formed by electroexplosion of wire.

After etching, the particles may be used in the formation of ohmic contacts on any suitable surface or substrate, for example on carbon, silicon, germanium, III-V semiconductors, 11-VI semiconductors, and 1-HI-VI semiconductors. These compounds, and their application in solid state electronic devices, are well known. All references herein to a Class of Compounds herein refers to the Class of Elements as set forth in the Periodic Table of the Elements, published by the American Chemical Society.

### EXAMPLE I

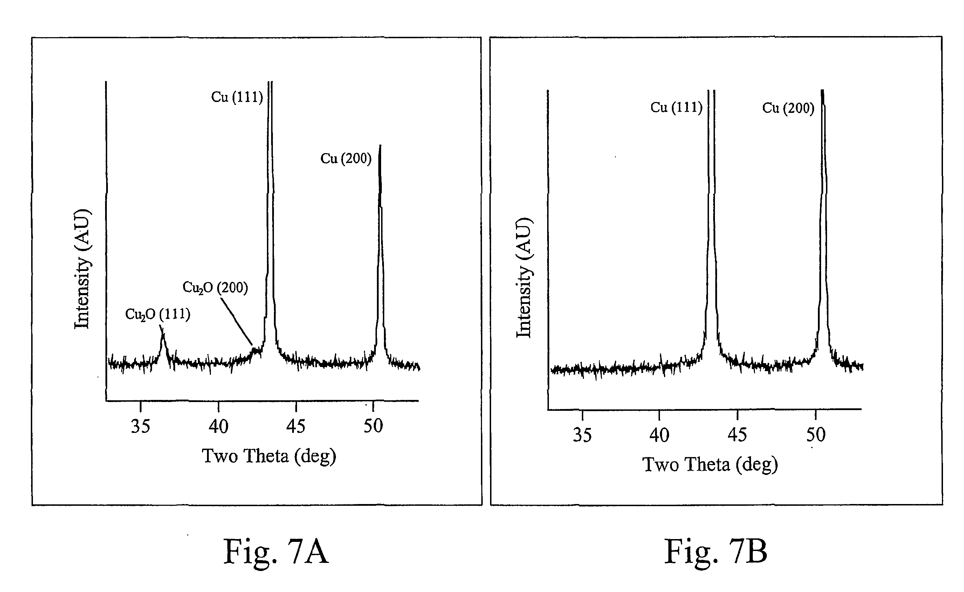

The following example illustrates the use of hfa, and in particular Cu(hfa)·VTMS, for etching the native oxide (Cu₂O) from the surface of copper nano-particles. The copper nanoparticles were also formed from the electroexplosion of copper wire and, as shown in Figure 7(A) after XRD characterization, are oxide coated, as received. The native oxide coating on the nano-sized Cu particles was removed at room temperature using a wet hexafluoracetylacetone chemical chelating etch. As shown in Figure 7(B), after etching the particles with hfa, the oxide layer was removed. It also can be seen that the Hhfa is coordinated to the Cu metal after the etch.

While the present invention has been described and illustrated in detail, it is clearly understood that the same is by way of illustration and example only and is not to be taken by way of limitation, the spirit and scope of the present invention being limited only by the terms of the appended claims.

## Claims

1. A process for etching native oxide layer from, and passivating the surface of, copper-nano particles, comprising:
(a) fornung a reaction mixture by dispersing the copper nano-particles in a solution consisting of Cu 1,1,1,5,5,5-hexaflouroacetylacetonate (hfa)·vinyltrimethylsilane (VTMS); and
(b) reacting the mixture for a time sufficient to etch and passivate the surface.

2. The process of claim 1 wherein the passivating surface layer is selected from the species consisting of oxide and hydroxide.

3. The process of claim 2 wherein the metal chelate consists of Cu(hfa)·VTMS, Hhfa.

4. The process of claim 3 wherein the metallic particles are copper.

5. The process of claim 3 further comprising, after reacting, washing the mixture in an organic solvent and then drying.

6. The process of claim 4 wherein the particles comprise nanoparticles in the range of 1-100 nm.

7. The process of claim 5 wherein the time is in a range of 1-24 hours.

8. The process of claim 5 wherein the organic solvent is selected from the group consisting of hexane or toluene.

## Patentansprüche

1. Verfahren zum Ätzen einer natürlichen Oxidschicht und zum Passivieren der Oberfläche von Kupfer-Nanopartikeln, das folgende Schritte umfasst:
(a) Bilden einer Reaktionsmischung durch Verteilen der Kupfer-Nanopartikel in einer Lösung , die aus Cu-1,1,1,5,5,5-Hexaflouroacethylacetonat (hfa) Vinyltrimethylsilan (VTMS) besteht; und
(b) Reagierenlassen der Mischung für eine Zeit, die ausreichend ist, um die Oberfläche zu Ätzen und zu Passivieren.

2. Verfahren nach Anspruch 1, wobei die zu passivierende Oberflächenschicht aus der aus Oxiden und Hydroxiden bestehenden Art bzw. Spezies ausgewählt wird.

3. Verfahren nach Anspruch 2, wobei das Metall-Chelat aus Cu(hfa) · VTMS, Hhfa besteht.

4. Verfahren nach Anspruch 3, wobei die Metallpartikel Kupfer sind.

5. Verfahren nach Anspruch 3, wobei die Mischung nach der Reaktion in einem organischen Lösungsmittel gewaschen und anschließend getrocknet wird.

6. Verfahren nach Anspruch 4, wobei die Partikel Nanopartikel im Bereich zwischen 1-10 nm umfassen.

7. Verfahren nach Anspruch 5, wobei die Zeit im Bereich zwischen 1-24 Stunden ist.

8. Verfahren nach Anspruch 5, wobei das organische Lösungsmittel aus der aus Hexan oder Toluen bestehenden Gruppe ausgewählt wird.

## Revendications

1. Procédé de gravure d'une couche d'oxyde natif et de passivation de la surface de nanoparticules de cuivre comprenant les étapes suivantes :
(a) former un mélange de réaction en dispersant les nanoparticules de cuivre dans une solution de Cu1,1,1,5,5,5-(hexafluoroacétylacétonate)vinyltriméthylsilane (Cu1,1,1,5,5,5-(hfa) VTMS) ; et
(b) faire réagir le mélange pendant une durée suffisante pour graver et passiver la surface.

2. Procédé selon la revendication 1, dans lequel la couche de passivation de surface est sélectionnée parmi les espèces oxyde et hydroxyde.

3. Procédé selon la revendication 2, dans lequel le chélate est choisi parmi Cu(hfa)-VTMS et Hhfa.

4. Procédé selon la revendication 3, dans lequel les particules métalliques sont du cuivre.

5. Procédé selon la revendication 3, comprenant en outre, après réaction, le lavage du mélange dans un solvant organique puis un séchage.

6. Procédé selon la revendication 4, dans lequel les particules comprennent des nano-particules dans la plage de 1 à 100 nm.

7. Procédé selon la revendication 5, dans lequel la durée est dans une plage de 1 à 24 heures.

8. Procédé selon la revendication 5, dans lequel le solvant organique est choisi dans le groupe comprenant l'hexane et le toluène.
